# EUROPEAN PATENT APPLICATION

(11) **EP 4 635 319 A1**
(43) Date of publication of application: **22.10.2025**
(21) Application number: 22968520.1
(22) Date of filing: 16.12.2022
(51) Int. Cl.: A24F 40/40, A24F 40/485

(54) **FLAVOR INHALER AND FLAVOR INHALATION SYSTEM**

(71) Applicant: Japan Tobacco Inc., Tokyo 105-6927 (JP)
(72) Inventor: ICHINOSE, Atsushi, Tokyo 130-8603 (JP); KOYAMA, Takahiro, Tokyo 130-8603 (JP)
(74) Representative: Hoffmann Eitle
(86) International application number: PCT/JP2022/046307
(87) International publication number: WO 2024/127610

(57) **Abstract**

The flavor inhaler comprises: a housing that has a ventilation opening; a battery that is positioned in a space in the interior of the housing, said space being in communication with the ventilation opening; and a covering member that covers at least a portion of the ventilation opening, wherein the covering member is bonded to the housing in a manner allowing the same to be removed from the housing, the covering member constitutes the bottom surface of a recess that is formed in the outer surface of the housing, and the depth of said recess is less than the thickness of the covering member.

## Description

### TECHNICAL FIELD

The present invention relates to a flavor inhaler and a flavor inhalation system.

### BACKGROUND ART

Flavor inhalers, which heat a material that includes a flavor source to generate an aerosol or the like, without burning the material, are conventionally known. In such a flavor inhaler, the pressure inside the flavor inhaler is increased by gas, etc., generated from the battery, which can cause failure of or damage to the flavor inhaler. In PTL 1, the aerosol generating device is provided with a ventilation opening to avoid an increase in pressure inside the housing.

### CITATION LIST

### PATENT LITERATURE

[PTL 1] WO 2021/023890 A1

### SUMMARY OF INVENTION

### TECHNICAL PROBLEM

In PTL 1, a sticker located to cover the ventilation opening is arranged at an end of the aerosol generating device. However, there is room for further improvement in such covering members.

In view of the above, it is an object of the present invention to provide a flavor inhaler and a flavor inhalation system with an improved covering member.

### SOLUTION TO PROBLEM

According to a first aspect, a flavor inhaler is provided. The flavor inhaler comprises: a housing having a ventilation opening; a battery arranged inside the housing in a space in communication with the ventilation opening; and a covering member covering at least a portion of the ventilation opening, wherein the covering member is bonded to the housing so that it can separate from the housing, the covering member constitutes a bottom surface of a recess formed on an outer surface of the housing, and a depth of the recess is smaller than a thickness of the covering member.

According to the first aspect, a flavor inhaler that is compactly configured having a ventilation opening more stably covered by the covering member, which is less prone to misalignment or detachment, can be provided.

The essential point of a second aspect is that, in the first aspect, the covering member comprises a peripheral portion facing the housing along a central axis of the ventilation opening, and adhesive is disposed between the peripheral portion and the housing.

According to the second aspect, the covering member and the housing can be bonded together taking advantage of the properties of the adhesive.

The essential point of a third aspect is that, in the second aspect, the adhesive is disposed in a strip-like manner, in which at a part of the peripheral portion a width of the adhesive is smaller than the width at the other parts of the peripheral portion.

According to the third aspect, the covering member can be more reliably peeled when the interior of the flavor inhaler is at the desired pressure.

The essential point of a fourth aspect is that, any of the second or third aspects further comprises a first region in which the adhesive is not disposed between the peripheral portion and the housing, surrounded by the adhesive.

According to the fourth aspect, the covering member can be more reliably peeled off when the interior of the flavor inhaler is at the desired pressure.

The essential point of a fifth aspect is that, any of the second to fourth aspects further comprises a second region in which the adhesive is not disposed, extending along a surface on which the covering member extends from the ventilation opening side of the peripheral portion to an opposite side thereof.

According to the fifth aspect, an increase in pressure inside the flavor inhaler can be reduced.

The essential point of a sixth aspect is that, in the first or second aspect, an amount or a property of the adhesive at the peripheral portion are non-uniform.

According to the sixth aspect, the covering member can be provided with an easily peeled portion to facilitate peeling of the covering member when the interior of the flavor inhaler is at the desired pressure.

According to a seventh aspect, a flavor inhalation system is provided. The flavor inhalation system comprises the flavor inhaler according to any one of first to sixth aspects, and consumable material.

According to the seventh aspect, a flavor inhalation system that is compactly configured having a ventilation opening more stably covered by the covering member, which is less prone to misalignment or detachment, can be provided.

### BRIEF DESCRIPTION OF DRAWINGS

FIG. 1 is an oblique view showing a flavor inhaler according to the present disclosure;
FIG. 2 is an oblique view of the flavor inhaler accommodating consumable material;
FIG. 3 is a cross-sectional view showing the flavor inhaler along the arrows 3-3 in FIG. 1;
FIG. 4 is a bottom surface view of the flavor inhaler;
FIG. 5 is an oblique view showing the bottom surface of the flavor inhaler;
FIG. 6 is a cross-sectional view schematically showing a ventilation opening and a covering member;
FIG. 7 is a conceptual view showing the ventilation opening;
FIG. 8 is a plan view showing the flavor inhaler with the sliding cover in an open position;
FIG. 9 is a plan view showing the flavor inhaler with the sliding cover in a closed position;
FIG. 10 is a conceptual view showing the flavor inhaler connected to an external device;
FIG. 11 is a cross-sectional view of the flavor inhaler showing the magnet of a sliding cover and a Hall sensor;
FIG. 12 is a conceptual view to illustrate detection of the position of the sliding cover;
FIG. 13 is a conceptual view to illustrate detection of the position of the sliding cover;
FIG. 14 is a cross-sectional view schematically showing a ventilation opening and covering member according to variant 1-1;
FIG. 15 is a conceptual view showing the distribution of the adhesive according to variant 1-1;
FIG. 16 is a conceptual view showing the distribution of the adhesive according to variant 1-2;
FIG. 17 is a conceptual view showing the distribution of the adhesive according to variant 1-3;
FIG. 18 is a conceptual view showing the distribution of the adhesive according to variant 1-4;
FIG. 19 is a plan view schematically showing the flavor inhaler according to variant 2-1;
FIG. 20 is a plan view schematically showing the flavor inhaler according to variant 2-2; and
FIG. 21 is a cross-sectional view schematically illustrating the arrangement of a magnet and Hall sensor in a conventional flavor inhaler.

### DESCRIPTION OF EMBODIMENTS

Embodiments of the present disclosure are described below with reference to the drawings. In the drawings described below, the same or corresponding components are indicated by the same symbols, and are not described more than once.

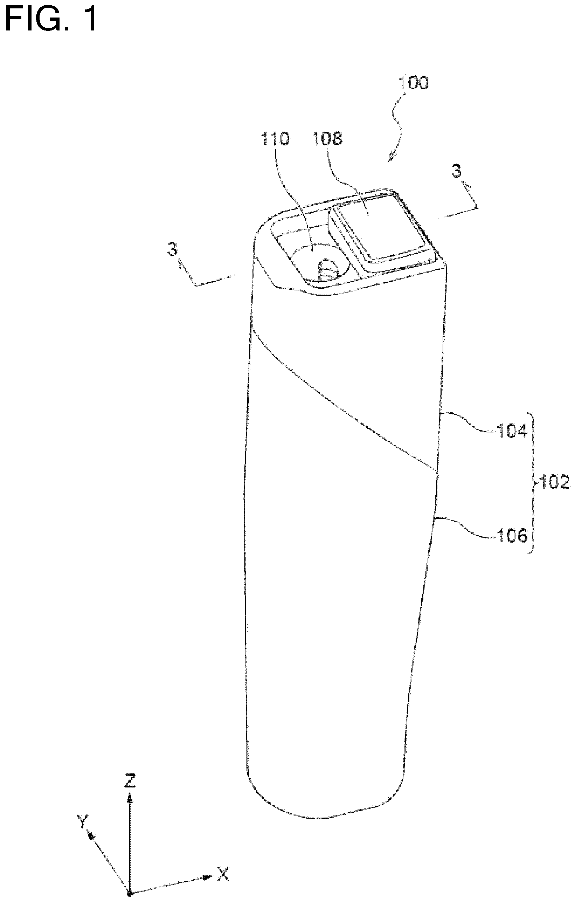

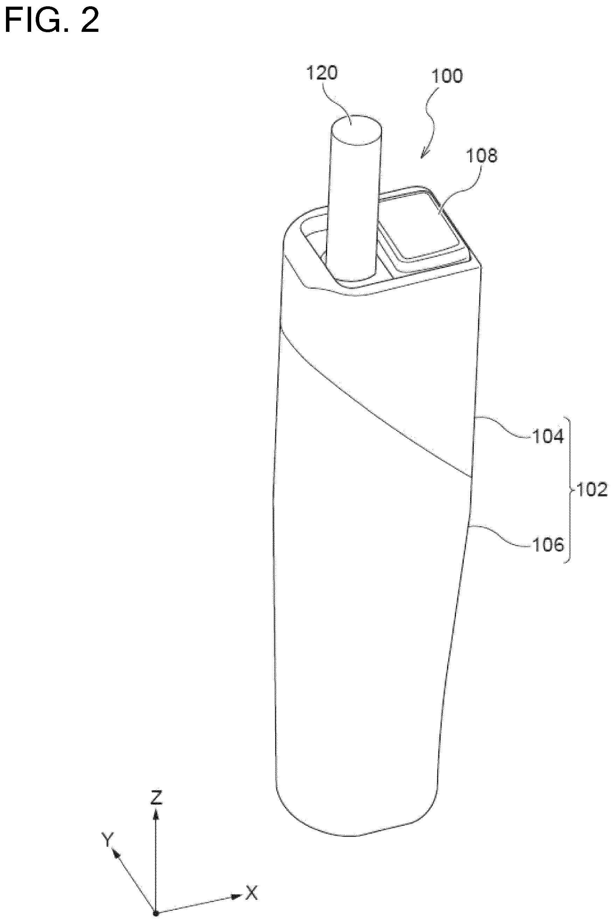

FIG. 1 is an oblique view showing a flavor inhaler 100 according to an embodiment of the present invention. FIG. 2 is an oblique view of the flavor inhaler 100 containing consumable material 120 inserted through an aperture 110. An X-Y-Z orthogonal coordinate system may be applied to the drawings described in the present specification for convenience of description. In this coordinate system, the Z-axis is oriented vertically upwards, the X-Y plane is arranged cutting across the flavor inhaler 100 in a horizontal direction, and the Y-axis is arranged extending from the front surface to the rear surface of the flavor inhaler 100. The Z-axis direction may also refer to a direction of insertion of the consumable material 120, which is accommodated in a chamber 50 to be described later. The X-axis direction can also refer to a device longitudinal direction in a plane perpendicular to the insertion direction of the consumable material 120. The Y-axis direction can also refer to a device lateral direction in a plane perpendicular to the insertion direction of the consumable material 120.

The flavor inhaler 100 is configured to generate an aerosol containing a flavor by, for example, heating stick-type consumable material 120 having a flavor source containing an aerosol source. As an example, the consumable material 120 comprises a smokable substance that contains a flavor source such as tobacco and an aerosol source on a tip end side in the Z-axis negative direction, and also comprises a filter on another part. Aerosol base materials that may be cited include glycerol, propylene glycol, triacetin, 1,3-butanediol, and mixtures thereof. It should be noted that in the present embodiment, the consumable material 120 is described as being stick-shaped, but the consumable material used in the flavor inhaler 100 is not limited to that shape. For example, the consumable material can also be configured to contain a cartridge accommodating a liquid aerosol source. Furthermore, this cartridge may include a heating part.

As shown in FIG. 1, the flavor inhaler 100 comprises a housing 102 formed from an upper housing 104 and a lower housing 106, and a sliding cover 108.

The housing 102 forms the outermost housing of the flavor inhaler 100 and is of a size that fits in the user's hand. When the user is using the flavor inhaler 100, the user can inhale the aerosol while holding the flavor inhaler 100 in their hand. It should be noted regarding the housing 102 in this case that the upper housing 104 is formed from a resin such as polycarbonate, for example, and the lower housing 106 is formed from a metal such as aluminum, for example. However, the housing 102 is not limited to the materials above and may also be made of a resin, for example, and it is possible to select any suitable material, such as, in particular, polycarbonate (PC), acrylonitrile-butadiene-styrene (ABS) resin, polyether ether ketone (PEEK), or a polymer alloy containing multiple types of polymers.

The upper housing 104 comprises the aperture 110 for receiving the consumable material 120, and the sliding cover 108 is slidably attached to the upper housing 104 so as to close the aperture 110. Specifically, the sliding cover 108 is configured to be capable of moving along an outer surface of the upper housing 104 between a closed position for closing the aperture 110 of the upper housing 104, and an open position (the position shown in FIGS. 1 and 2) for opening the aperture. For example, the user can manually operate the sliding cover 108 to move the sliding cover 108 between the closed position and the open position. As a result, the sliding cover 108 can permit or restrict access of the consumable material 120 to the inside of the flavor inhaler 100.

Here, FIGS. 1 and 2 show the housing 102 of the flavor inhaler 100 with the mating surfaces of the upper housing 104 and the lower housing 106 obliquely intersecting the X-Y plane, but the housing 102 is not limited to such a configuration. For example, the housing 102 may also be formed from three or more members.

The flavor inhaler 100 may further include a terminal, which is not shown in the drawings. The terminal may be an interface for connecting the flavor inhaler 100 to an external power source, for example. When the power source of the flavor inhaler 100 is a rechargeable battery, the external power source can be connected to the terminal so that current is supplied from the external power source to the power source, and the power source can be charged. Furthermore, data relating to operation of the flavor inhaler 100 may also be sent to an external device by connecting a data transmission cable to the terminal.

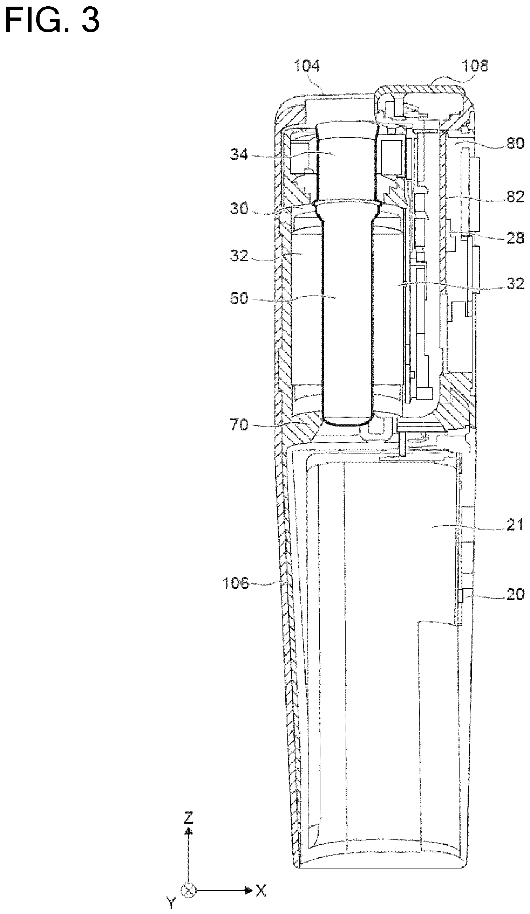

Next, the internal structure of the flavor inhaler 100 is described. FIG. 3 is a cross-sectional view of the flavor inhaler 100 as viewed in the direction of the arrows 3-3 shown in FIG. 1.

As shown in FIG. 3, a power source unit 20, an atomization unit 30, and a control unit 80 are provided in an internal space of the housing 102 of the flavor inhaler 100.

The control unit 80 comprises a board 82. The board 82 can comprise a microprocessor or the like, for example, and can control the supply of power from the power source unit 20 to the atomization unit 30. This enables the control unit 80 to control heating of the consumable material 120 by the atomization unit 30. Furthermore, the control unit 80 comprises a Bluetooth (registered trademark) interface 28. The control unit 80 can communicate with an external device via the Bluetooth interface 28.

The power source unit 20 comprises a power source 21 that is electrically connected to the board 82 of the control unit 80. The power source 21 may be a rechargeable battery or a non-rechargeable battery, for example. The power source 21 is electrically connected to the atomization unit 30 via the board 82. This allows the power source 21 to supply power to the atomization unit 30 to heat the consumable material 120 appropriately.

The atomization unit 30 comprises: the chamber 50 extending in the longitudinal direction of the consumable material 120; a heating part 40 (not shown in FIG. 3) surrounding part of the chamber 50; a heat insulating portion 32; and a substantially cylindrical insertion guide member 34. The chamber 50 is configured to accommodate the consumable material 120. The heating part 40 is configured to contact an outer circumferential surface of the chamber 50 to heat the consumable material 120 accommodated in the chamber 50. It is also possible, for example, to provide a susceptor inside or in proximity to the consumable material 120, and to configure the heating part 40 to comprise an induction coil for inductively heating the susceptor.

The heat insulating portion 32 is arranged so as to cover the chamber 50 and the heating part 40. The heat insulating portion 32 may be aerogel, for example. The insertion guide member 34 is formed from a resin material such as PEEK, PC, or ABS, for example, and is provided between the sliding cover 108 in the closed position and the chamber 50. The insertion guide member 34 communicates with the outside of the flavor inhaler 100 when the sliding cover 108 is in the open position, and guides the insertion of the consumable material 120 into the chamber 50 when the consumable material 120 is inserted into the insertion guide member 34.

Furthermore, the atomization unit 30 and the control unit 80 are covered by a heat diffusion sleeve 70 and arranged in an interior space of the housing 102. The heat diffusion sleeve 70 is made from a material with a high thermal conductivity, such as a metal, to diffuse heat generated in the atomization unit 30 inside the housing 102. The heat diffusion sleeve 70 can be configured so as not to interfere with the lower housing 106 and to be arranged inside only the upper housing 104. The heat diffusion sleeve 70 can also be provided with an open region so as not to interfere with communication with an external device by the Bluetooth interface 28 of the control unit 80. Although the metal member generally interferes with electromagnetic waves, the control unit 80 can communicate with an external device via the Bluetooth interface 28 through at least the open region of the heat diffusion sleeve 70 as a path.

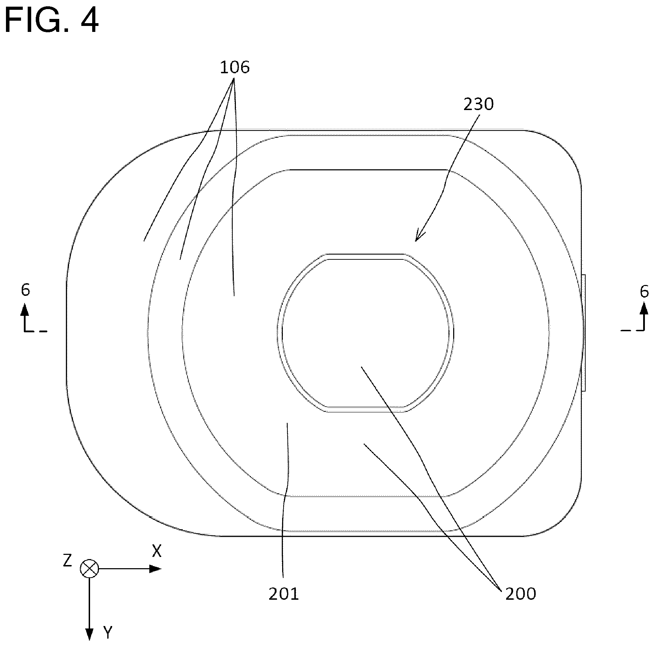

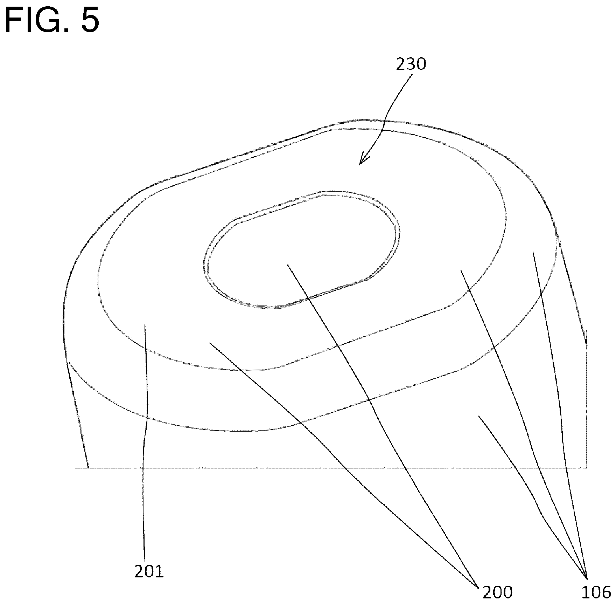

FIG. 4 is a bottom view of the flavor inhaler 100. FIG. 5 is an oblique view that includes the bottom surface 200 of the flavor inhaler 100. The flavor inhaler 100 has a first recess 230 formed in the bottom surface 200. The first recess 230 is formed surrounded by the housing bottom surface 201, which is the bottom surface of the housing 102 including the lower housing 106.

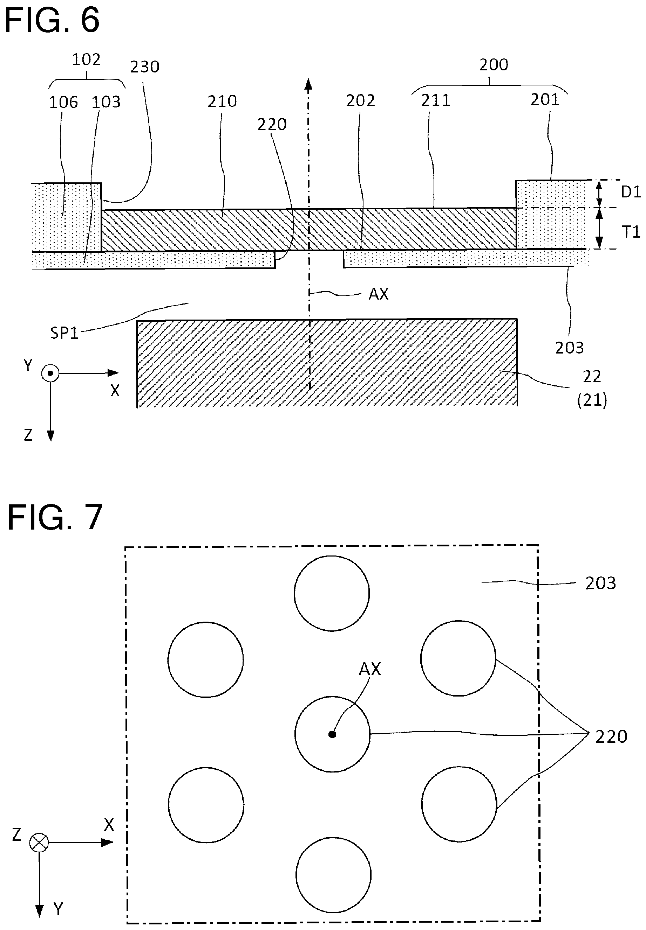

FIG. 6 is a cross-sectional view schematically showing the first recess 230. The flavor inhaler 100 comprises a covering member 210. The housing 102 comprises an inner housing 103. The inner housing 103 is located inside the lower housing 106. A ventilation opening 220 is formed in the inner housing 103, and the covering member 210 is arranged to cover at least a portion of the ventilation opening 220. The covering member 210 defines the first recess 230. An outer surface 211, which is the outer surface of the covering member 210, constitutes the bottom surface of the first recess 230. The sides of the first recess 230 are formed by the lower housing 106.

In the present embodiment, the power source 21 comprises a battery 22. The battery 22 is arranged in a space SP1 formed inside the housing 102. The battery 22 may be rechargeable or not. The battery 22 is, for example, a lithium-ion battery. The ventilation opening 220 is in communication with the space SP1 in which the battery 22 is arranged. In the present embodiment, the ventilation opening 220 opens towards the bottom surface 200 of the flavor inhaler 100, but there is no particular limitation on the position of the ventilation opening 220 as long as it is in communication with the space SP1.

The covering member 210 is bonded to an adhesive surface 202, which is an outer surface of the inner housing 103. The covering member 210 and the adhesive surface 202 are configured to be capable of separating. In other words, the covering member 210 can be peeled from the adhesive surface 202 with a force that does not damage the covering member 210 or the inner housing 103. Preferably, the covering member 210 is arranged over the whole ventilation opening 220. In this case, the covering member 210 may be configured to be separated from the adhesive surface 202 based on the pressure of the space SP1. For example, when the pressure inside the flavor inhaler 100 exceeds a threshold pressure that does not adversely affect the equipment inside the flavor inhaler 100, the covering member 210 is configured so that a gap is created between the covering member 210 and the adhesive surface 202 and gas is released from the space SP1. There may be a gap between the outer circumferential surface of the covering member 210 and the inner circumferential surface of the lower housing 106. This enables smooth release of gas when a flow path is formed between the covering member 210 and the adhesive surface 202. This gap is preferably narrow to prevent the accumulation of water, dust, etc., in the first recess 230. In this way, preferably at least a portion of the outer circumferential surface of the covering member 210 is separated slightly from the inner circumferential surface of the lower housing 106. In other words, preferably the covering member 210 is slightly smaller than the first recess 230 along the adhesive surface 202.

There is no particular limitation on the shape of the covering member 210, provided it can cover at least a portion of the ventilation opening 220. Preferably, the covering member 210 is sheet-like or seal-like, in order to increase the area for adhesion and achieve compactness. There is no particular limitation on the material of the covering member 210, and it can be paper or a synthetic resin such as polycarbonate (PC), polyethylene terephthalate, or polyvinyl chloride. Preferably, the covering member 210 comprises a water-resistant synthetic resin in order to prevent water ingress inside the flavor inhaler 100.

There is a possibility that members bonded to the housing 102 or the like may be peeled off by a user or be peeled off or misaligned due to contact with external members. In the flavor inhaler 100 of the present embodiment, the covering member 210 covering the ventilation opening 220 is arranged in the first recess 230, whereby contact with a user's finger or an external member becomes difficult, making it possible to reduce these issues. It is also possible to prevent the adhesive from leaking onto the surface of the housing 102. Furthermore, the depth D1 of the first recess 230 is smaller than the thickness T1 of the covering member 210. If the depth D1 is too large, the smoothness of the outer surface of the flavor inhaler 100 is lost and there is an increased risk of debris such as water and dust being deposited in the first recess 230. If the thickness T1 is too small, the covering member 210 is prone to tearing due to contact with a needle or the like. Having a depth D1 smaller than a thickness T1 allows the flavor inhaler 100 to be compact while taking these into consideration. In addition, the depth D1 of the first recess 230 is smaller than the thickness T1 of the covering member 210, which facilitates the recognition of defective products as the covering member 210 protrudes from the housing bottom surface 201 if multiple coated members 210 are accidentally placed on top of each other during manufacture of the flavor absorber 100. As a non-limiting example, the thickness T1 of the covering member 210 is 0.2 mm or more and 0.4 mm or less, and the depth D1 of the first recess 230 is 0.2 mm or less.

FIG. 7 is a conceptual view showing ventilation openings 220 in an inner surface 203, which is the inner surface of the inner housing 103. In the illustrated example, the ventilation openings 220 are defined by a cylindrical side wall around their central axis AX. Also, a plurality of ventilation openings 220 is formed on the inner surface 203, with each ventilation opening 220 arranged at a position corresponding to the center and each apex of a hexagon. However, there is no particular limitation on the shape, number, and position of the ventilation openings 220. Note that in the illustrated example, the lower housing 106 and the inner housing 103 are separate members, but may be integrally formed.

The flavor inhaler 100 and the consumable material 120 constitute a flavor inhalation system. The flavor inhaler 100 and the flavor inhalation system of the present embodiment comprise: the housing 102 having the ventilation openings 220, the battery 22 arranged inside the housing 102 in the space SP1 in communication with the ventilation opening 220, and the covering member 210 covering at least a portion of the ventilation openings 220, wherein the covering member 210 is bonded to the housing 102 so that it can be separated from the housing 102, the covering member 210 constitutes the bottom surface of the first recess 230 formed in the housing bottom surface 201, which is an outer surface of the housing 102, and the depth D1 of the first recess 230 is smaller than the thickness T1 of the covering member 210. In this way, it is possible to provide a flavor inhaler 100 and flavor inhalation system that is compactly configured having a ventilation opening 220 more stably covered by the covering member 210, which is less prone to misalignment or detachment.

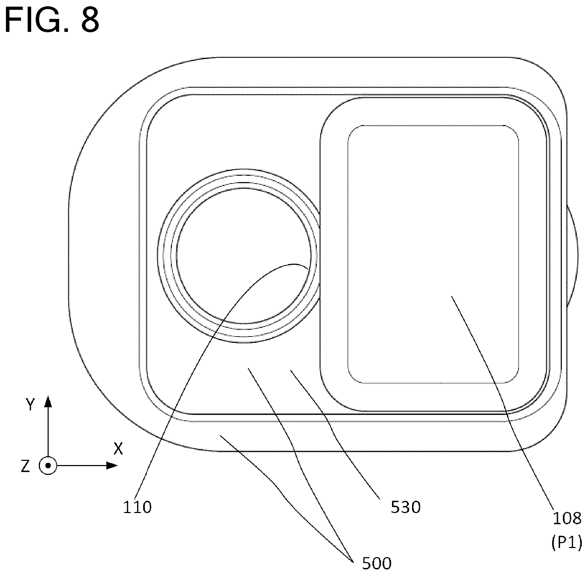

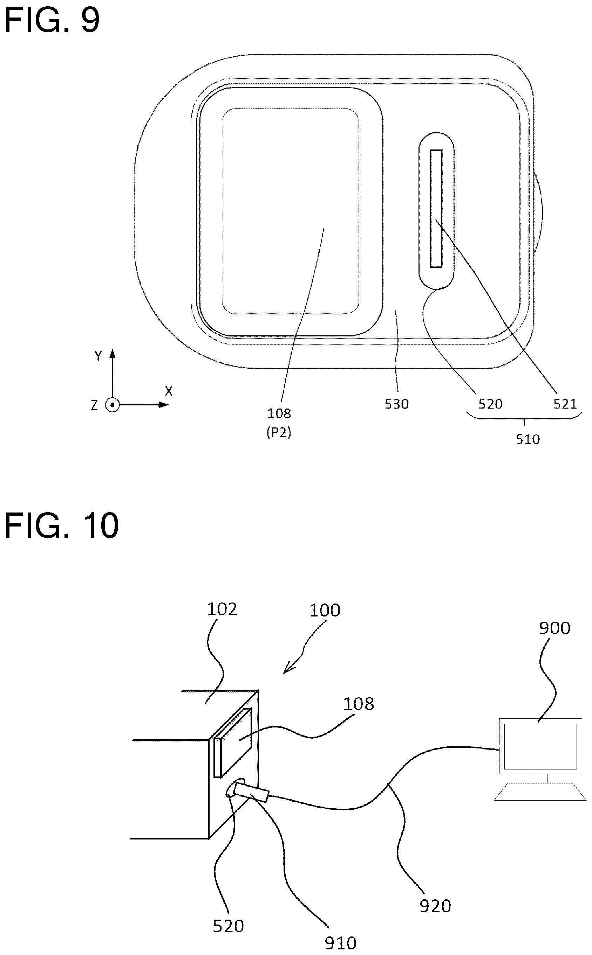

FIG. 8 is a plan view showing the flavor inhaler 100 when the sliding cover 108 is in the first position P1. FIG. 9 is a plan view showing the flavor inhaler 100 when the sliding cover 108 is in the second position P2. The flavor inhaler 100 has a second recess 530 formed on its upper surface 500. The flavor inhaler 100 comprises an interface portion 510. The interface portion 510 comprises an aperture 520 formed in the upper surface 500, and a connection portion 521. In the following, the above-mentioned aperture 110 in which the consumable material 120 is inserted is referred to as the first aperture 110 and the aperture 520 is referred to as the second aperture 520. In the illustrated example, the first aperture 110 and the interface portion 510 are formed in the second recess 530, but the first aperture 110 and the interface portion 510 need not be formed in the recess.

The interface portion 510 mediates the exchange of information, data, or power, etc., between the control unit 80 or the power source unit 20 and the exterior of the flavor inhaler 100. In the present embodiment, the connection portion 521 comprises a connection terminal for an external device. A terminal of the external device is inserted into the second aperture 520 and is electrically connected to the connection terminal of the connection portion 521. In the illustrated example, the connection terminal of the connection portion 521 has a plate-like shape protruding inside the second opening 520, but there is no particular limitation on the shape of the connection portion 521 provided an electrical connection is possible.

The first position P1 is a position in which the sliding cover 108 covers at least a portion of the interface portion 510. In the first position P1, the sliding cover 108 obstructs connection from an external device to the connection portion 521. It is preferable that the first position P1 is an open position in which insertion of the consumable material 120 into the first aperture 110 is possible, as in the illustrated example.

The second position P2 is a position covering at least a portion of the first aperture 110. In the second position P2, the sliding cover 108 obstructs insertion of the consumable material 120 into the first aperture 110. In the second position P2, as in the illustrated example, it is preferable that connection from an external device to the connection portion 521 is possible.

The sliding cover 108 is a member configured to be capable of moving between the first position P1 and the second position P2. In the present embodiment, the sliding cover 108 is moved by sliding, but movement of the moveable member between the first position P1 and the second position P2 may be by pivoting, or the like. In order to configure the flavor inhaler 100 in a compact manner, it is preferable that the moveable member can slide between the first position P1 and the second position P2.

The first aperture 110 and the interface portion 510 are preferably formed on the upper surface 500, which is one end face of the longitudinally extending housing 102. This reduces the distance travelled by the sliding cover 108, and allows the flavor inhaler 100 to be configured simply and compactly.

In the present embodiment, the sliding cover 108 is configured to be capable of moving between the first position P1 covering at least a portion of the interface portion 510, in particular the second aperture 520, and the second position P2 covering at least a portion of the first aperture 110. This can make the connection between the connection portion 521 and an external device difficult when consumable material 120 is inserted into the first aperture 110. The adverse effects of foreign matter, such as secondhand smoke from heating of the consumable material 120 or smoke exhaled by the user, on the interface portion 510 can therefore be reduced. It can also be difficult for the user to insert the consumable material 120 into the first aperture 110 when the interface portion 510 is in use, such as when the terminal of an external device is connected to the connection portion 521. Accordingly, when the interface portion 510 is in use, heating of the consumable material 120 can be prevented, and generation of foreign matter such as secondhand smoke can be reduced. In this way, in the present embodiment, the negative effect of foreign matter on the interface portion 510 can be reduced by making it difficult to insert the consumable material 120 and use the interface portion 510 at the same time.

It is preferable that the sliding cover 108 does not cover the first aperture 110 in the first position P1. This can prevent the connection portion 521 from being connected to an external device when the consumable material 120 is inserted into the first aperture 110. The adverse effects of foreign matter, such as secondhand smoke, on the interface portion 510 can therefore be further reduced.

It is preferable that the sliding cover 108 does not cover the interface portion 510, in particular the second aperture 520, in the second position P2. This can prevent insertion of the consumable material 120 into the first aperture 110 by the user when the interface portion 510 is in use. For example, the connection between the connection portion 521 and an external device is only possible when the first aperture 110 is covered by the sliding cover 108. With such an arrangement, when the interface portion 510 is in use, the consumable material 120 is not heated, thereby reducing generation of foreign matter such as secondhand smoke and reducing adverse effects of foreign matter on the interface portion 510.

In view of the foregoing, it is more preferable that the sliding cover 108 is configured to be capable of moving between the first position P1 in which it covers at least a portion of the interface portion 510 and does not cover the first aperture 110, and the second position P2 in which it covers at least a portion of the first aperture 110 and does not cover the interface portion 510.

FIG. 10 is a conceptual view showing the connection of the flavor inhaler 100 and an external device 900. The connection portion 521 is electrically connected to the external device 900 via an external terminal 910 and a conductor 920. At least one of a computer, a power source, an input device, and an indication device can be configured to be connected as the external device 900. This can enable the setting of or charging of the flavor inhaler 100, or display of information about the flavor inhaler 100, and so on. From a similar perspective, the connection portion 521 is preferably electrically connected to at least one of the control unit 80 and the power source unit 20 inside the flavor inhaler 100.

Preferably, the connection portion 521 comprises a USB port capable of communication according to the Universal Serial Bus (USB) standard. This enables various functions such as data input/output and charging, and makes use of the convenience of USB connection, such as plug and play.

As shown in FIGS. 8 and 9, the shapes of the first aperture 110 and the second aperture 520 are preferably different. This can reduce the risk of accidentally inserting the consumable material 120 into the second aperture 520 or inserting the external terminal 910 into the first aperture 110. This can prevent scratches and foreign matter from entering the inside of the flavor inhaler 100.

The flavor inhaler 100 preferably comprises a detector that detects whether the sliding cover 108 is in the first position P1 or the second position P2. In the following, the points regarding detecting the sliding cover 108 comprising a magnet by a detector comprising a Hall sensor is described.

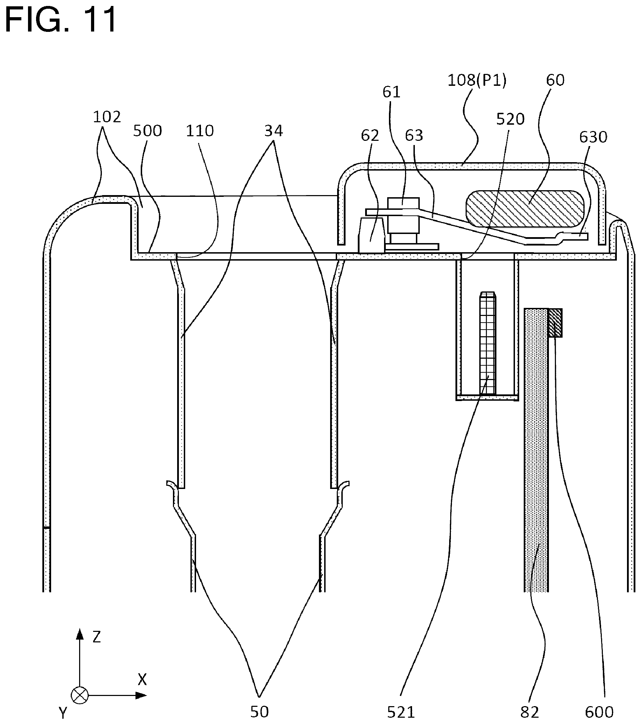

FIG. 11 is a cross-sectional view schematically showing a Hall sensor 600, and a magnet 60 arranged in the sliding cover 108. FIG. 11 corresponds to an enlarged view of the cross-section at 3-3 in FIG. 1 at the top of the flavor inhaler 100, and omits illustration of parts as appropriate in accordance with their relevance to the following description. FIG. 11 shows a sliding cover 108 in the first position P1 covering the second aperture 520 on the upper surface 500 side of the connection 521.

The magnet 60 is arranged inside the sliding cover 108. In the illustrated example, the magnet 60 is supported by a support that is not shown, and is configured to move integrally with the sliding cover 108. There is no particular limitation on the size of the magnet 60 or its position relative to the sliding cover 108 provided it moves as the sliding cover 108 moves. There is no particular limitation on the type of magnet, but a permanent magnet is preferred as no wiring is required.

As long as the sliding cover 108 can move between the first position P1 and the second position P2, there is no particular limitation regarding its embodiment. In the illustrated example, a first protrusion 61 extending in the Z-axis direction is fixed to the upper surface 500 of the housing 102, and an elongated hole is formed in a plate-like member that is not shown on the drawings, extending in the X-axis direction and fixed to the sliding cover 108 and extending along the XY plane, with the inner wall of the elongated hole configured to slide along the first protrusion 61. The first aperture 110 and the second aperture 520 are formed in the center of the upper surface 500 in the Y-axis direction, and for stability, the first protrusion 61 and the elongated hole are formed on both sides, to the outside in the Y-axis direction of the first aperture 110 and the second aperture 520. However, a guide member may be provided on the upper surface 500 of the housing 102, and the sliding cover 108 may slide along the guide member. The plate-like member is preferably made of metal for increased strength.

Also in the illustrated example, a biasing member 63 is arranged in the sliding cover 108. The biasing member 63 comprises an elastic member, such as a metal, which extends plate-like in the X-axis direction, with an engagement part 630 formed at its end. When the sliding cover 108 is moved to the second position P2, a second protrusion 62 fixed to the upper surface 500 is engaged on the negative Z-axis side of the engagement part 630. The engagement part 630 is provided with a step or the like so that it is difficult for the second protrusion 62 to move when engaged with the second protrusion 62. The assembly may be configured so that there is an audible click when the second protrusion 62 engages with the step of the engagement portion 630. The biasing member 63 is configured to bias the second protrusion 62 so that the engagement part 630 does not disengage from the second protrusion 62 with a slight force, but disengages when a user slides the sliding cover 108 by hand. This allows the sliding cover 108 to be more stably held in the second position P2. The flavor inhaler 100 may comprise another set of second protrusion 62 and biasing member 63 so that it can be held stably in this way when the sliding cover 108 is in the first position P1. It should be noted that the second protrusion 62 and the biasing member 63 need not be arranged in the flavor inhaler 100.

The Hall sensor 600 is arranged in a position so that the magnet 60 in the first position P1 or the second position P2 can be detected There is no particular limitation on the position of the Hall sensor 600 provided it detects a magnetic field of different magnitude when the magnet 60 is in the first position P1 and the second position P2, or if it is able to detect a magnetic field at only one of the positions. In the illustrated example, the distance between the Hall sensor 600 and the first position P1 is less than the distance between the Hall sensor 600 and the second position P2. Therefore, it is possible to render the assembly such that the Hall sensor 600 can detect the magnet 60 of the sliding cover 108 in the first position P1, and cannot detect the magnet 60 of the sliding cover 108 in the second position P2 from the Hall sensor 600. The Hall sensor 600 is electrically connected to the control unit 80. For a simpler configuration, the Hall sensor 600 is preferably arranged on the board 82 as in the illustrated example. Also the Hall sensor is preferably arranged at the end of the board 82 on the upper surface 500 side, for highly sensitive detection of the magnetic field of the magnet 60.

In the present embodiment, the sliding cover 108 is configured to move along the upper surface 500 extending substantially parallel to the XY plane, and the board 82 is arranged along a YZ plane intersecting the upper surface 500. This arrangement allows the board 82 to extend in the longitudinal direction of the flavor inhaler 100 and to arrange a wide board 82 in the compact flavor inhaler 100 while reducing the distance travelled by the sliding cover 108 and keeping the configuration simple.

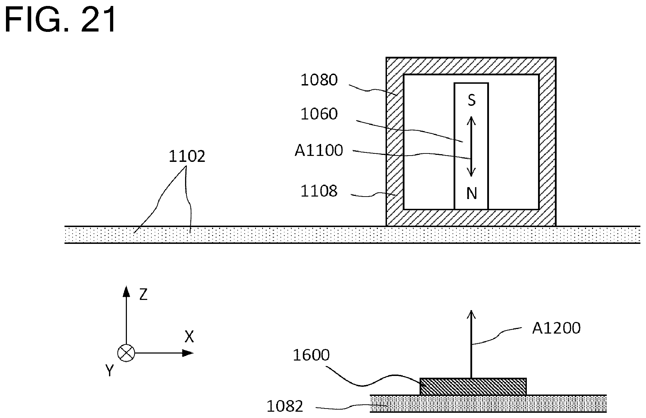

FIG. 21 is a conceptual view to illustrate detection of a magnet 1060 in a sliding cover 1080 in a conventional flavor inhaler. In the following, the direction through both poles of the magnet is referred to as the magnet direction, and the direction of the magnetic field detected by the Hall sensor is referred to as the detection direction. In the conventional flavor inhaler, a housing 1102 and a board 1082 are arranged in parallel and the magnet direction (arrow A1100) through the poles of the magnet 1060 is arranged perpendicular to the housing 1102. In this case, the detection direction of the magnetic field at the Hall sensor 1600 (arrow A1200) and the magnet direction can be in line, enabling efficient detection by the Hall sensor 1600. On the other hand, in the present embodiment, it is not easy to arrange the magnetic field detection direction and the magnet direction in the same line, as the Hall sensor 600 is arranged on the board 82 extending along a surface that intersects the upper surface 500 of the housing 102 as shown in FIG. 11.

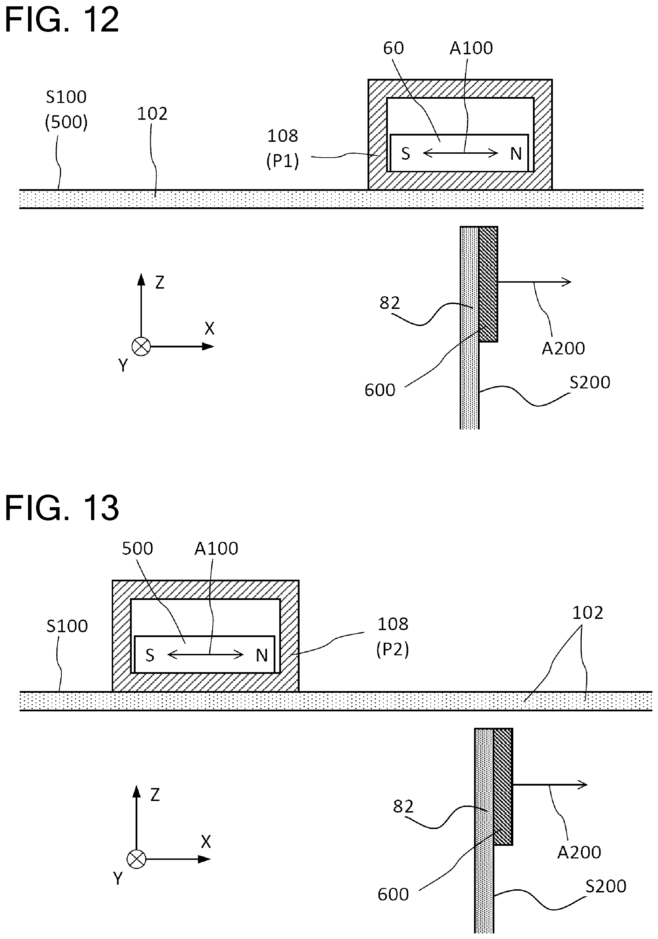

FIG. 12 is a cross-sectional view schematically illustrating the configuration of the magnet 60 and the Hall sensor 600 in the first position P1 in the present embodiment. FIG. 13 is a cross-sectional view schematically illustrating the configuration of the magnet 60 and the Hall sensor 600 in the second position P2 in the present embodiment.

The sliding cover 108 is configured to be capable of moving along a first surface S100, which corresponds to the upper surface 500 of the housing 102. The magnet 60 is arranged in the sliding cover 108 so that the magnet direction through the N and S poles of the magnet 60 is along the first surface S100. In FIG. 12, the magnet direction is shown schematically with arrow A100. The angle between the first surface S100 and the magnet direction is preferably no more than 30 degrees, and more preferably no more than 15 degrees. A small angle between the first surface S100 and the magnet direction makes it easier to arrange a longer magnet 60. The longer the magnet 60, the stronger the magnetic force, further facilitating the detection of the magnetic field by the Hall sensor 600.

The board 82 is arranged intersecting the magnet direction. In other words, the board 82 is arranged along a second surface S200, which is a surface that intersects the magnet direction. The angle between the magnet direction and the second surface S200 is preferably greater than or equal to 60 degrees and less than or equal to 120 degrees, more preferably greater than or equal to 75 degrees and less than or equal to 105 degrees, and still more preferably the magnet direction and the second surface S200 are substantially perpendicular. The closer this angle is to the perpendicular, the easier it is to configure a smaller angle between the detection direction and the direction of the magnetic field of the magnet 60 at the Hall sensor 600, and the easier it is to detect the magnetic field.

The Hall sensor 600 comprises a Hall element and processing circuitry to process the output of the Hall element. The processing circuitry comprises an operational amplifier, for example, amplifying the output of the Hall element. In order to make it easier to detect the magnetic field of the magnet 60, the Hall sensor 600 and its Hall element are arranged to detect a magnetic field substantially parallel to the magnet direction. Preferably, the Hall sensor 600 is arranged on the board 82 so that the detection direction of the Hall sensor 600 is substantially perpendicular to the board 82. This allows the Hall sensor 600 to be arranged on the board 82 in a simpler or more compact configuration.

There is no particular limitation on the type and detection method of the Hall sensor 600 provided the magnetic field of the magnet 60 can be detected. However, the Hall sensor 600 is preferably configured to not perform bipolar detection. In the present embodiment, as both poles of the magnet 60 can approach the Hall sensor 600, the detected magnetic field varies in a complex manner, and if both poles are detected, a complex process may be required to determine the position of the sliding cover 108. This possibility can be reduced by the Hall sensor 600 being configured to only perform unipolar detection, for example.

The angle between the first surface S100 and second surface S200 is preferably greater than or equal to 60 degrees and less than or equal to 120 degrees, and more preferably greater than or equal to 75 degrees and less than or equal to 105 degrees. The board 82 preferably extends substantially perpendicular to the first surface S100. This enables the board 82 to be extended in a direction perpendicular to the direction of movement, even if the distance travelled by the sliding cover 108 is reduced, and a large area of board 82 can be installed.

The magnet direction and the second surface S200 preferably intersect between the two poles of the magnet 60 in the state where the sliding cover 108 is in the first position P1 or the second position P2, which is the detected position. More specifically, in FIG. 12, the position in the X-axis direction of the board 82 is preferably between the positions in the X-axis direction of the two poles of the magnet 60. This enables the angle between the detection direction and the direction of the magnetic field of the magnet 60 at the first position P1 or the second position P2 to be reduced, allowing a more sensitive detection of the magnetic field of the magnet 60.

The control unit 80 controls the flavor inhaler 100 based on the output from the Hall sensor 600. The control unit 80 preferably controls heating of the heating part 40 based on output from the Hall sensor 600. For example, an ON signal detecting a magnetic field or an OFF signal not detecting a magnetic field is output from the Hall sensor 600 to the control unit 80. When the control unit 80 receives the ON signal, there is a sliding cover 108 in the first position P1 and the first aperture 110 is in an open state, allowing heating. When the control unit 80 receives the OFF signal, heating can be prevented because there is no sliding cover 108 in the first position P1 and the first aperture 110 is in a closed state. With this arrangement, wasteful heating can be reduced and a more efficient and safer flavor inhaler can be provided.

The flavor inhaler 100 and the flavor inhalation system of the present embodiment comprise the sliding cover 108 having the magnet 60 and that can move along the first surface S100, and the board 82 comprising the Hall sensor 600, wherein the magnet 60 is arranged in the sliding cover 108 so that the direction through its two poles is along the first surface S100, and the board 82 is arranged along the second surface S200 that intersects with that direction. As a result, the flavor inhaler 100 and the flavor inhalation system capable of detecting the position of the sliding cover 108 with sufficiently high sensitivity even when the direction of movement of the sliding cover 108 moving with the magnet 60 intersects the surface on which the board 82 on which the Hall sensor 600 is arranged extends can be provided.

### Variant 1-1

In the embodiments described above, the amount or the properties of the adhesive that bonds the covering member 210 and the adhesive surface 202 of the inner housing 103 may be uneven due to the position on the adhesive surface 202. For the sake of clarity, the following will be described with an example when the number of ventilation openings 220 is one.

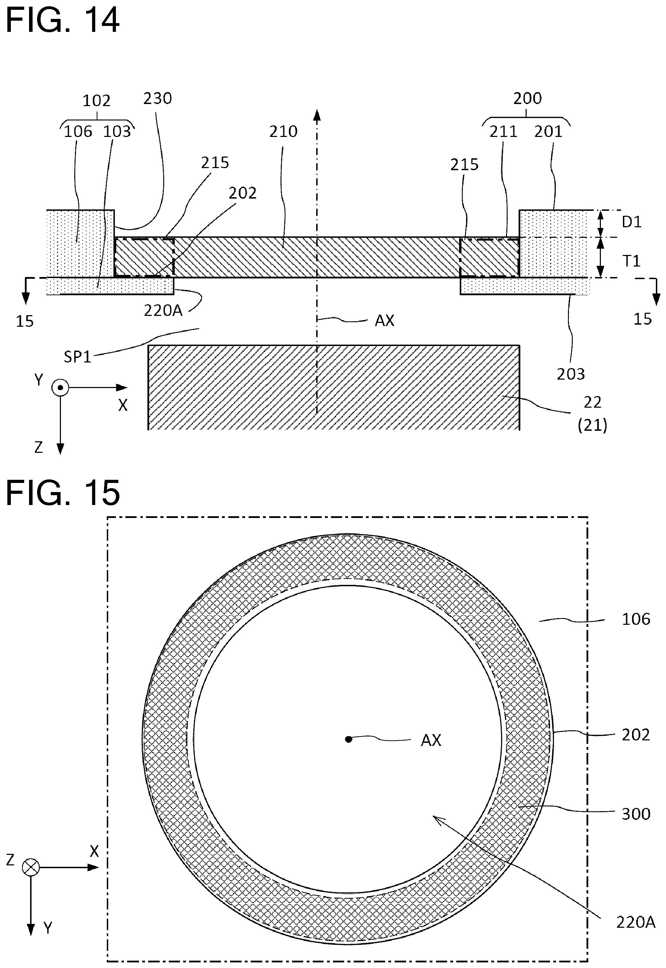

FIG. 14 is a cross-sectional view schematically illustrating a ventilation opening 220A and the covering member 210 according to the present variant. FIG. 15 is a conceptual view showing the ventilation opening 220A and an adhesive layer 300, showing a cross section 15-15 (FIG. 14) perpendicular to the central axis AX. The hatching of the lower housing 106 is omitted. In the illustrated example, the ventilation opening 220A is formed with rotational symmetry about the central axis AX and is a circular through hole when viewed from the bottom surface 200 side.

As shown in FIG. 14, the covering member 210 has a peripheral portion 215 facing the inner housing 103 along the central axis AX. In the present variant, the peripheral portion 215 is a strip formed surrounding the ventilation opening 220A, but there is no particular limitation on the shape of the peripheral portion 215. Hereinafter, "strip-shaped" includes the case where the covering member 210 is formed along a closed curve so that it is circular. Including cases where the flavor inhaler 100 has multiple ventilation openings 220 formed therein as in the embodiment described above, the peripheral portion of the covering member 210 that faces the wall portion in which the ventilation opening 220 is formed along the central axis AX is referred to as the peripheral portion 215. The peripheral portion 215 faces the adhesive surface 202 of the inner housing 103. The peripheral portion 215 is arranged surrounding the one or a plurality of ventilation openings 220.

As shown in FIG. 15, the adhesive layer 300, which is a layer of adhesive, is formed between the peripheral portion 215 of the covering member 210 and the adhesive surface 202 of the inner housing 103. There is no particular limitation regarding the type of adhesive in the adhesive layer 300, and it can be, for example, a resin or the like. The amount or the properties of the adhesive layer 300 on the adhesive surface 202 are preferably uneven. As a result, a part that can be easily peeled is provided on the covering member 210, making it easier to peel the covering member 210 when the interior of the flavor inhaler 100 is at the desired pressure. There is no particular limitation regarding the properties of the adhesive that differ depending on the position on the adhesive surface 202, provided they affect the ease with which the covering member 210 can be peeled off, and may be, for example, the adhesive strength.

### Variant 1-2

In variant 1-1 as described above, on a portion of the peripheral portion 215, the width of the adhesive layer 300 that contacts the peripheral portion 215 may be different from the width of the adhesive layer 300 that contacts the other parts of the peripheral portion 215.

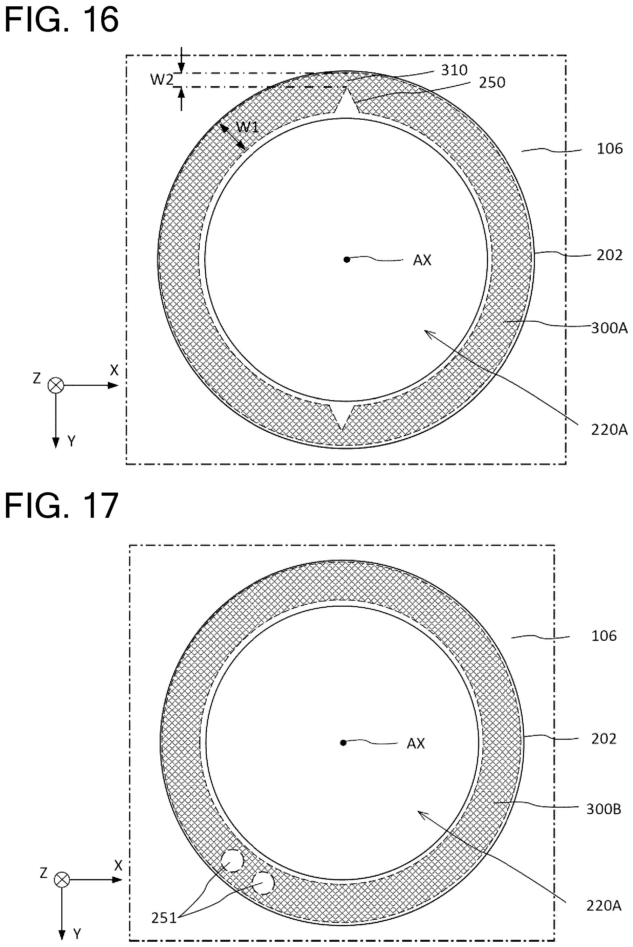

FIG. 16 is a conceptual view showing an adhesive layer 300A according to the present variant. The adhesive layer 300A is formed in a strip-like shape with a first width W1. However, at two circumferential locations about the central axis AX, a gap 250 between the covering member 210 and the adhesive surface 202 protrudes into the adhesive layer 300A, and the portion of the adhesive layer 300A facing the gap 250 constitutes a weak area 310 having a second width W2 that is smaller than the first width W1. In the illustrated example, the adhesive layer 300 has two weak areas 310, but there is no particular limitation regarding the number and location of the weak areas 310.

In the flavor inhaler 100 of the present variant, the adhesive is arranged in a strip, wherein at a portion of the peripheral portion 215 the width of the adhesive is smaller than the width of the other parts of the peripheral portion 215. This can make it easier for the covering member 210 to peel off more reliably when the interior of the flavor inhaler 100 is at the desired pressure.

### Variant 1-3

In variant 1-1, the flavor inhaler 100 may further comprise an adhesive-free area between the peripheral portion 215 and the adhesive surface 202 of the housing 102, that is surrounded by adhesive.

FIG. 17 is a conceptual view showing an adhesive layer 300B according to the present variant. The flavor inhaler 100 comprises a first region 251 surrounded by the adhesive layer 300B in a plane perpendicular to the central axis AX. The first region 251 is a region where the adhesive is not located. Preferably, the first region 251 is an air layer. In this case also, the covering member 210 can be more reliably peeled off when the interior of the flavor inhaler 100 is at the desired pressure.

### Variant 1-4

In variant 1-1, an airflow path may be formed in communication with the interior and exterior of the flavor inhaler 100 through the adhesive layer 300.

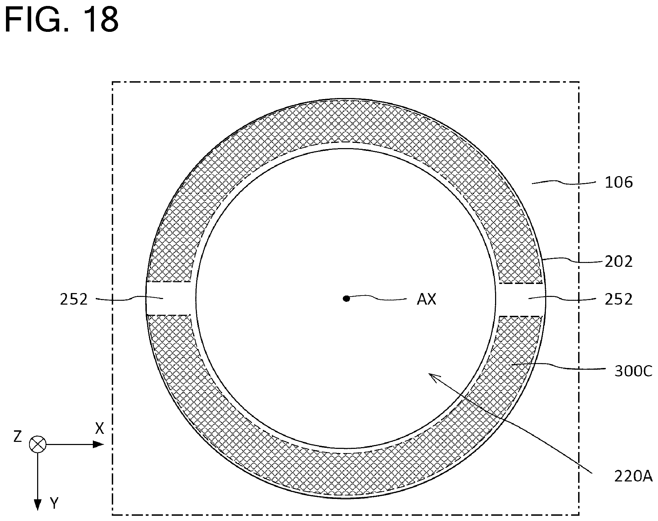

FIG. 18 is a conceptual view showing an adhesive layer 300C according to the present variant. The flavor inhaler 100 comprises a second region 252. The second region 252 is a region where no adhesive is provided that extends radially in between the covering member 210 and the adhesive surface 202. The second region 252 is an air flow path in communication with the interior and exterior of the flavor inhaler 100. In the illustrated example, because the adhesive layer 300C is annular, the second region 252 extends radially from the inside to the outside of the adhesive layer 300C. In this way, the flavor inhaler 100 further comprises the adhesive-free second region 252 extending along the surface (XY plane) on which the covering member 210 extends from the ventilation opening 220A side of the peripheral portion 215 to the opposite side. As a result, it is possible to restrict the rise of pressure on the inside of the flavor inhaler 100.

### Variant 1-5

In the embodiments described above, the adhesive of the adhesive layer 300 may be configured to be easily peeled off due to heat when gas is generated from the battery 22. For example, an adhesive can be used so that the adhesive strength decreases at temperatures higher than the normal temperature range occurring during flavor suction. This can make it easier for the covering member 210 to be peeled off more reliably when the interior of the flavor inhaler 100 is at the desired pressure.

### Variant 2-1

In the embodiments described above, an input portion such as a button or the like may be arranged on the upper surface 500 in addition to or as an alternative to the second aperture 520.

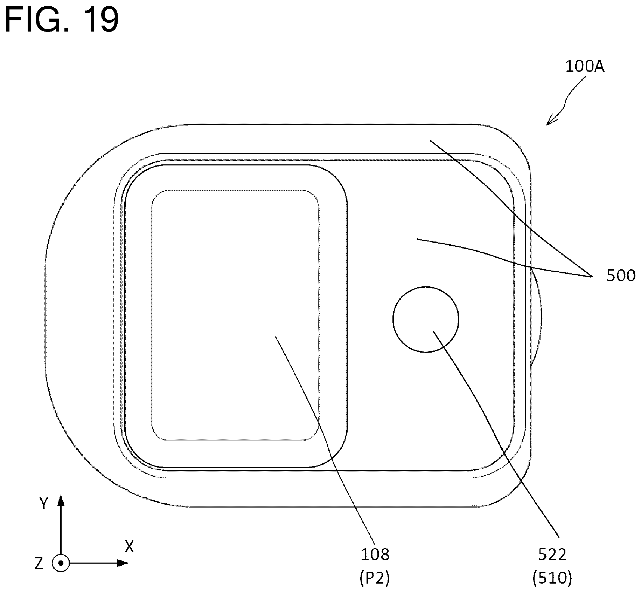

FIG. 19 is a plan view schematically illustrating a flavor inhaler 100A according to the present variant. The flavor inhaler 100A has a substantially similar configuration to the flavor inhaler 100 described above, but differs from the flavor inhaler 100 in that, as the interface portion 510, an input portion 522 is provided instead of the second aperture 520.

The input portion 522 comprises an input device. In the illustrated example, the input portion 522 is a button. However, the input portion 522 is not limited thereto and can comprise any input device that can be arranged on the upper surface 500. For example, the input 522 can comprise a touch panel or a switch, and so on. The input portion 522 may act as an operation portion for a user to operate parts of the flavor inhaler 100A.

The flavor inhaler 100A is configured so that when the sliding cover 108 is in the first position P1, at least a portion of the input portion 522 is covered by the sliding cover 108 and the input portion 522 cannot be operated by the user. As shown in FIG. 19, the flavor inhaler 100A is configured so that when the sliding cover 108 is in the second position P2, at least a portion of the first aperture 110 is covered and consumable material 120 cannot be inserted into the first aperture 110. When the sliding cover 108 is in the second position P2, the input portion 522 may be operated by the user.

Such an arrangement can make it difficult for the input portion 522 to be operated by the user when consumable material 120 is inserted into the first aperture 110. Also, when the input portion 522 is in use, insertion of the consumable material 120 into the first aperture 110 by the user can be made difficult. Thus, the generation of foreign matter such as secondhand smoke or user-exhaled smoke and contact of the foreign matter with the input portion 522 can be reduced, and adverse effects of the foreign matter on the input portion 522 can be reduced.

### Variant 2-2

In the embodiments as described above, an indicator such as a display or the like may be arranged on the upper surface 500 in addition to or as an alternative to the second aperture 520.

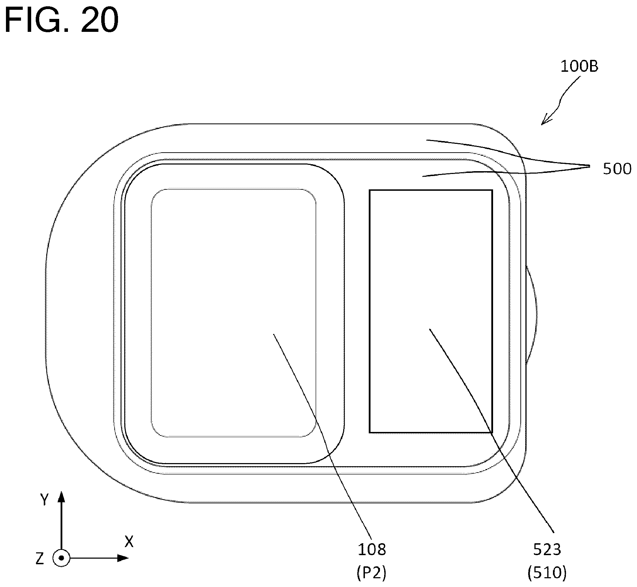

FIG. 20 is a plan view schematically illustrating a flavor inhaler 100B according to the present variant. The flavor inhaler 100B has a substantially similar configuration to that of the flavor inhaler 100 described above, but differs from the flavor inhaler 100 in that an indicator 523 is provided as the interface portion 510 instead of the second aperture 520.

The indicator 523 comprises a display device. In the illustrated example, the indicator 523 is a display such as a liquid crystal monitor. However, the indicator 523 is not limited thereto and can comprise any display device that can be arranged on the top surface 500. For example, the indicator 523 can comprise a touch panel, a light emitting diode, or the like. If the indicator 523 is a light emitting diode, the status of the flavor inhaler 100B can be indicated by whether it is lit or not.

In the flavor inhaler 100B, when the sliding cover 108 is in the first position P1, at least a portion of the indicator 523 is covered by the sliding cover 108. As shown in FIG. 20, the flavor inhaler 100B is configured so that when the sliding cover 108 is in the second position P2, at least a portion of the first aperture 110 is covered and consumable material 120 cannot be inserted into the first aperture 110. The indicator 523 may be configured to be visible to the user when the sliding cover 108 is in the second position P2.

With such an arrangement, the indicator 523 can be less exposed when consumable material 120 is inserted into the first aperture 110. Also, when the indicator 523 is exposed, insertion of the consumable material 120 into the first aperture 110 by the user can be made difficult. Therefore, the generation of foreign matter such as secondhand smoke or user-exhaled smoke and contact between the foreign matter and the indicator 523 can be reduced, and adverse effects of the foreign matter on the indicator 523 can be prevented.

Embodiments of the present invention were described above, but the present invention is not limited to those embodiments, and various modifications are possible within the scope of the technical concept disclosed in the claims, specification and drawings. Moreover, any shape or material not directly stated in the specification or drawings is also within the scope of the technical concept of the invention of this application provided that it exhibits the action and effect of the invention of this application.

According to a first aspect of the present invention, the flavor inhaler comprises: a housing having a ventilation opening; a battery arranged inside the housing in a space in communication with the ventilation opening; and a covering member covering at least a portion of the ventilation opening, wherein the covering member is bonded to the housing so that it can separate from the housing, the covering member constitutes a bottom surface of a recess formed on an outer surface of the housing, and a depth of the recess is smaller than a thickness of the covering member.
According to a second aspect of the present invention, in the first aspect, the covering member comprises a peripheral portion facing the housing along a central axis of the ventilation opening, and adhesive is disposed between the peripheral portion and the housing.
According to a third aspect of the present invention, in the second aspect, the adhesive is arranged in a strip-like manner, in which at a part of the peripheral portion a width of the adhesive is smaller than the width at the other parts of the peripheral portion.
According to a fourth aspect of the present invention, the second or third aspect further comprises a first region in which adhesive is not disposed between the peripheral portion and the housing, surrounded by the adhesive.
According to a fifth aspect of the present invention, any one of the second to fourth aspects further comprises a second region in which the adhesive is not disposed, extending along a surface on which the covering member extends from the ventilation opening side of the peripheral portion to an opposite side thereof.
According to a sixth aspect of the present invention, in the first or second aspect, an amount or a property of the adhesive at the peripheral portion are non-uniform.
A flavor inhalation system according to a seventh aspect of the present invention comprises the flavor inhaler according to any of the first to sixth aspects, and consumable material.

### REFERENCE SIGNS LIST

20: Power source unit
21: Power source
28: Bluetooth interface
30: Atomization unit
32: Heat insulating part
34: Insertion guide member
40: Heating part
50:Chamber
60, 1060: Magnet
70: Heat diffusion sleeve
80: Control unit
82, 1082: Board
100, 100A, 100B: Flavor inhaler
102, 1102: Housing
103: Inner housing
104: Upper housing
106: Lower housing
108, 1108: Sliding cover
110: First aperture
120: Consumable material
200: Bottom surface
201: Housing bottom surface
202: Adhesive surface
203: Housing inner surface
210: Covering member
211: Covering member outer surface
215: Peripheral portion
220, 220A: Ventilation opening
230: First recess
251: First region
252: Second region
300, 300A, 300B: Adhesive layer
500: Upper surface of the flavor inhaler
510: Interface portion
520: Second aperture
521: Connection portion
522: Input portion
523: Indicator
600, 1600: Hall element
900: External device
910: External terminal
AX: Central axis of the ventilation opening
D1: Depth of the first recess
P1: First position
P2: Second position
SP1: Space
S100: First surface
S200: Second surface
T1: Thickness of the covering member
W1: First width
W2: Second width

## Claims

1. A flavor inhaler, comprising: a housing having a ventilation opening;
a battery arranged inside the housing in a space in communication with the ventilation opening; and
a covering member covering at least a portion of the ventilation opening, wherein
the covering member is bonded to the housing so that it can separate from the housing,
the covering member constitutes a bottom surface of a recess formed on an outer surface of the housing, and
a depth of the recess is smaller than a thickness of the covering member.

2. The flavor inhaler as claimed in claim 1, wherein the covering member comprises a peripheral portion facing the housing along a central axis of the ventilation opening, and
adhesive is disposed between the peripheral portion and the housing.

3. The flavor inhaler as claimed in claim 2, wherein the adhesive is disposed in a strip-like manner, in which at a part of the peripheral portion a width of the adhesive is smaller than the width at the other parts of the peripheral portion.

4. The flavor inhaler as claimed in claim 2 or claim 3, further comprising a first region in which the adhesive is not disposed, between the peripheral portion and the housing , surrounded by the adhesive.

5. The flavor inhaler as claimed in any one of claims 2 to 4, further comprising a second region in which the adhesive is not disposed, extending along a surface on which the covering member extends from the ventilation opening side of the peripheral portion to an opposite side thereof.

6. The flavor inhaler as claimed in claim 1 or claim 2, wherein an amount or a property of the adhesive at the peripheral portion are non-uniform.

7. A flavor inhalation system, comprising: the flavor inhaler as claimed in any one of claims 1 to 6; and
consumable material.
